# EUROPEAN PATENT APPLICATION

(11) **EP 4 273 919 A1**
(43) Date of publication of application: **08.11.2023**
(21) Application number: 22846880.7
(22) Date of filing: 08.08.2022
(51) Int. Cl.: H01L 23/12

(54) **SEMICONDUCTOR PACKAGE AND HIGH FREQUENCY MODULE**

(30) Priority: 16.03.2022 JP 2022041146
(71) Applicant: FUJIKURA LTD., Tokyo 135-8512 (JP)
(72) Inventor: TOMITA, Michikazu, Sakura-shi Chiba 2858550 (JP)
(74) Representative: Lavoix
(86) International application number: PCT/JP2022/030260
(87) International publication number: WO 2023/176006

(57) **Abstract**

A semiconductor package includes an RFIC chip, a mold resin that surrounds the RFIC chip in a planar view, a plurality of solder bumps, and a plurality of redistributors that connect the RFIC chip to the plurality of solder bumps, wherein a first bump group disposed in a position that overlaps with the RFIC chip in the planar view, and a second bump group disposed in a position that overlaps with the mold resin in the planar view are included in the plurality of solder bumps, in the second bump group, at least a high frequency bump connected to a high frequency terminal of the RFIC chip, and a GND bump connected to a GND terminal of the RFIC chip are included, and a minimum pitch in the second bump group is larger than a minimum pitch in the first bump group.

## Description

### [Technical Field]

The present invention relates to a semiconductor package and a high frequency module.

Priority is claimed on Japanese Patent Application No. 2022-041146, filed March 16, 2022, the contents of which are incorporated herein.

### [Background Art]

In Patent Document 1, a semiconductor package having a configuration where an RFIC is embedded in a mold resin is disclosed. Such a semiconductor package is mounted on a substrate or the like by means of a plurality of solder bumps. Typically, a pitch between solder bumps for mounting a semiconductor package on a substrate is set to be constant.

### [Citation List]

### [Patent Document]

[Patent Document 1] Japanese Unexamined Patent Application, First Publication No. 2021-141370

### [Summary of Invention]

### [Technical Problem]

In a semiconductor package that deals with high frequency signals, downsizing of the semiconductor package while satisfying high frequency characteristics is desired. To downsize a semiconductor package, by only making a pitch of solder bumps smaller, there are problems that it is difficult to dispose a high frequency circuit of a substrate side while maintaining high frequency characteristics, and route a high frequency circuit of a substrate side.

The present invention is made in light of the above-described circumstances, where the objective is to provide a semiconductor package capable of downsizing a connected substrate while maintaining high frequency characteristics, and a high frequency module configured of a semiconductor package and a substrate.

### [Solution to Problem]

To resolve the problem presented above, a semiconductor package according to an aspect of the present invention includes an RFIC chip, a mold resin that surrounds the RFIC chip in a planar view, a plurality of solder bumps, and a plurality of redistributors that connect the RFIC chip to the plurality of solder bumps, wherein, a first bump group disposed in a position that overlaps with the RFIC chip in the planar view, and a second bump group disposed in a position that overlaps with the mold resin in the planar view are included in the plurality of solder bumps, in the second bump group, at least a high frequency bump connected to a high frequency terminal of the RFIC chip, and a GND bump connected to a GND terminal of the RFIC chip are included, and a minimum pitch in the second bump group is larger than a minimum pitch in the first bump group.

All the high frequency terminals that the RFIC chip includes may be connected to the second bump group.

All digital signal terminals that the RFIC chip includes may be connected to the first bump group.

The plurality of redistributors and the plurality of solder bumps may be disposed so as not to overlap in the planar view with respect to a high frequency circuit block that the RFIC chip includes.

The RFIC chip at least may include two high frequency circuit blocks, and in the planar view, at least a part of the first bump group may be positioned between the two high frequency circuit blocks.

In the planar view, the plurality of solder bumps may be disposed symmetrically to both a first centerline and a second centerline that are orthogonal to one another.

A high frequency module according to an aspect of the present invention includes the semiconductor package mentioned above, a substrate on which the semiconductor package is mounted, wherein the substrate includes a high frequency pad joined to the high frequency bump and a GND pad joined to the GND bump, and the high frequency pad and the GND pad are each disposed on via holes formed in the substrate.

### [Advantageous Effects of Invention]

According to an above aspect of the present invention, it is possible to provide a semiconductor package capable of downsizing a connected substrate while maintaining high frequency characteristics, and a high frequency module configured of a semiconductor package and a substrate.

### [Brief Description of Drawings]

FIG. 1 is a plan view of a semiconductor package according to a present embodiment.
FIG. 2 is a schematic diagram of a cross section along a thickness direction of a part of a semiconductor package according to a present embodiment.
FIG. 3 is a schematic diagram of a cross section along a thickness direction of a part of a high frequency module according to a present embodiment.

### [Description of Embodiments]

Hereon, a semiconductor package and a high frequency module according to a present embodiment are explained with reference to the drawings.

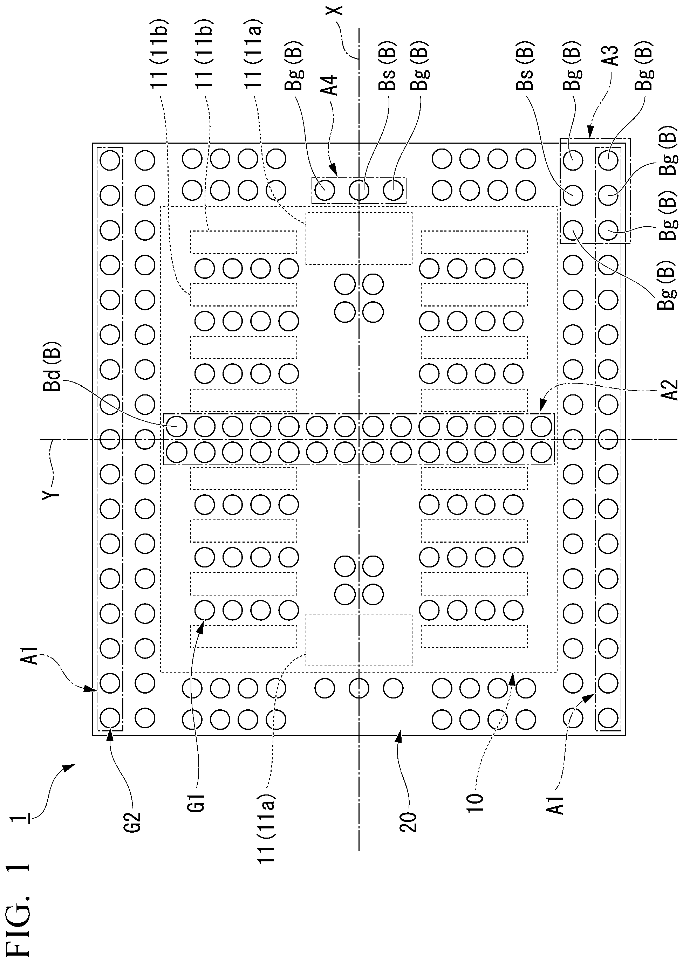

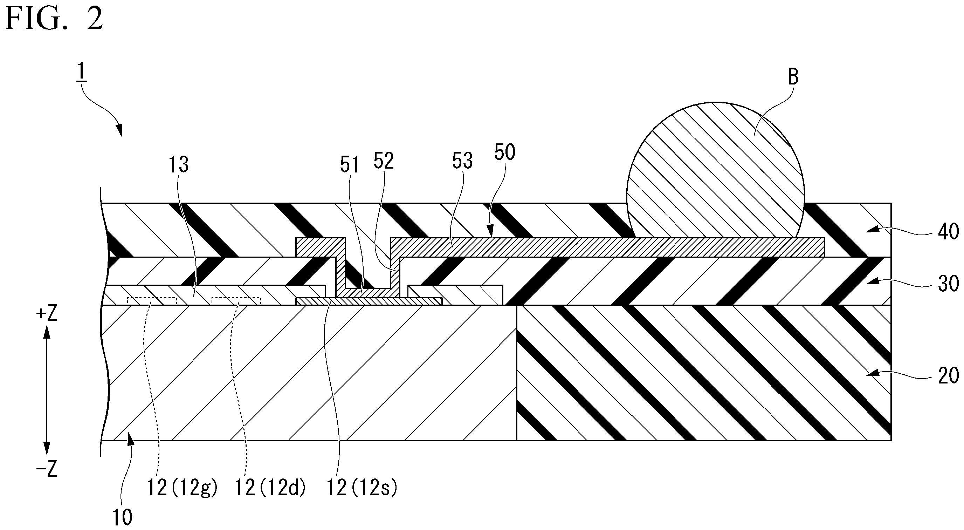

FIG. 1 is a view of a semiconductor package 1 of the present embodiment as seen from a thickness direction. FIG. 2 is a schematic diagram of a cross section along a thickness direction of a part of the semiconductor package 1.

As shown in FIG. 1 and FIG. 2, the semiconductor package 1 includes an RFIC chip 10, a mold resin 20, a first insulation layer 30, a second insulation layer 40, a plurality of redistributors 50, and a plurality of bumps B.

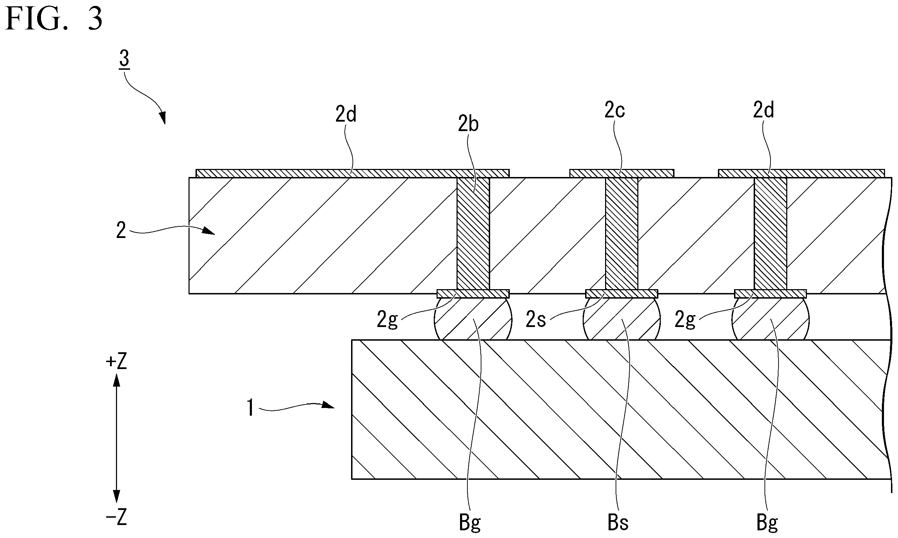

As shown in FIG. 3, the semiconductor package 1 is used as a part that configures a high frequency module 3. The high frequency module 3 includes a substrate 2, and a semiconductor package 1 mounted on the substrate 2. The substrate 2 includes a plurality of pads (high frequency pad 2s, a GND pad 2g or the like), to which the bumps B (high frequency bump Bs, GND bump Bg or the like, together to be mentioned later on) are joined. From this, the substrate 2 is electrically connected to the semiconductor package 1.

### (Definition of Directions)

Viewing the semiconductor package 1 from the thickness direction is referred to as a planar view. The thickness direction of the semiconductor package 1 is also a direction that the semiconductor package 1 and the substrate 2 opposes. A figure in which the semiconductor package 1 is plan viewed is referred to as a plan view. As shown in FIG. 2 and FIG. 3, the thickness direction is expressed by the Z axis. In a thickness direction, a semiconductor package 1 side is expressed as a bottom side, or a - Z side, and a substrate 2 side is expressed as an upper side or a +Z side. Further, the +Z side is not necessarily an upper side with respect to the direction of gravity. FIG 1 is a plan view of the semiconductor package 1 seen from the +Z side.

As shown in FIG. 1, the semiconductor package 1 of the present embodiment is formed in a rectangular shape in a planar view, and it is possible to define a first centerline X and a second centerline Y that are orthogonal to one another. In other words, the semiconductor package 1 includes two sides parallel to the first centerline X, and two sides parallel to the second centerline Y. From hereon, there are cases where a direction along the first centerline X is referred to as an X direction, and a direction along the second centerline Y is referred to as a Y direction.

In the present embodiment, a plurality of solder bumps B disposed in a position that overlaps with the RFIC chip 10 in a planar view are referred to as a first bump group G1, and a plurality of solder bumps B disposed in a position that overlaps with the mold resin 20 in a planar view are referred to as a second bump group G2. Each of the solder bumps B is roughly spherical in shape as shown in FIG. 2. Each of the solder bumps B protrudes from the second insulation layer 40 to the +Z side. It is possible to use SAC305, SAC405 or the like as materials for the solder bumps B above.

On an inside of the RFIC chip 10, a plurality of high frequency circuit blocks 11 are provided to process high frequency signals (for example, signals of 28 GHz band, 60 GHz band). The RFIC chip 10 may additionally include a digital circuit to conduct processing of digital signals. On FIG. 1, positions of the high frequency circuit blocks 11 are shown by dashed lines. Each high frequency circuit block 11 includes an analog circuit (inductor or the like), and is configured to process high frequency signals.

In the plurality of high frequency circuit blocks 11, two first high frequency circuit blocks 11a disposed on the first centerline X, and sixteen second high frequency circuit blocks 11b disposed away from the first centerline X in the Y direction are included. A width in the X direction of the first high frequency circuit block 11a is larger than a width of the second high frequency circuit block 11b. Both the first high frequency circuit blocks 11a and the second high frequency circuit blocks 11b are disposed to be symmetrical with respect to both the first centerline X and the second centerline Y. However, the numbers, shapes, dispositions and so on of the first high frequency circuit blocks 11a and the second high frequency circuit blocks 11b shown in FIG. 1 serve as an example, and may be changed accordingly.

The mold resin 20 surrounds the RFIC chip 10 in a planar view. As shown in FIG. 2, the RFIC chip 10 and the mold resin 20 are in the same position in the thickness direction. The RFIC chip 10 is embedded in the mold resin 20, and the RFIC chip 10 and the mold resin 20 are in contact with one another. It is possible to adopt epoxy as specific example of a material of the mold resin 20. A filler such as silica or the like may be included in the mold resin 20.

It is possible to adopt the so called FOWLP (Fan Out Wafer Level Package) as a method of manufacturing the semiconductor package 1. As a specific example, a plurality of RFIC chips 10 may be disposed in a lattice shape, mold resin 20 may be filled in the gaps between the RFIC chips 10, and the redistributor 50 or the like may be formed, after which the mold resin 20 may be cut. According to such a manufacturing method, it is possible to efficiently obtain a plurality of semiconductor packages 1 at one time.

As shown in FIG. 2, it is preferable that the mold resin 20 of the like is not provided in the bottom surface (end surface of the -Z side) of the RFIC chip 10, and the RFIC chip 10 is exposed. From this, it is possible to increase the heat dissipation of the RFIC chip 10. Alternatively, to increase heat dissipation, a structure (heat dissipation sheet, heat dissipation fins or the like) may be provided on the bottom surface of the RFIC chip 10.

As shown in FIG. 2, a plurality of terminals 12 are disposed on the upper surface (end surface of the +Z side) of the RFIC chip 10. Each of the terminals 12 for example, is a pad made of aluminum. According to functions, it is possible to classify the plurality of terminals 12 to a high frequency terminal 12s, a GND terminal 12g, a digital signal terminal 12d and a power terminal (not shown in figure). The high frequency terminal 12s is electrically connected to the high frequency circuit block 11, and is a terminal 12 in which a high frequency signal flows through. The GND terminal 12g is electrically connected to a GND circuit (not shown in figure) of the RFIC chip 10 and is a terminal 12 that is set to be GND potential. The digital signal terminal 12d is electrically connected to a digital circuit (not shown in figure) of the RFIC chip 10, and is a terminal 12 in which a digital signal flows through. The power terminal is a terminal 12 that supplies an electric drive power to the various parts of the RFIC chip 10.

As shown in FIG. 2, the high frequency terminal 12s is electrically connected to the solder bump B by means of the redistributor 50. Although omitted from the figure, other terminals 12 (the GND terminal 12g, the digital signal terminal 12d, and the power terminal) each are electrically connected to the solder bumps B by means of the redistributors 50.

In the present description, the bump B connected to the high frequency terminal 12s is referred to as a "high frequency bump Bs." The bump B connected to the GND terminal 12g is referred to as a "GND bump Bg." The bump B connected to the digital signal terminal 12d is referred to as a "digital bump Bd."

The solder bumps B and the redistributors 50 are disposed so as not to overlap with the high frequency circuit block 11 in a planar view. In this manner, it is possible to suppress the effects of metallic parts (solder bump B and redistributor 50) on the high frequency characteristics (for example, inductance value) of the RFIC chip 10 by disposing the metallic parts so as not to overlap with the high frequency circuit block 11.

As shown in FIG. 2, a passivation film 13 is provided on the upper surface of the RFIC chip 10. The passivation film 13 is for example a nitride film, an oxide film or the like, and is responsible for protecting the RFIC chip 10. However, for the sake of the connection of the terminals 12 and the redistributors 50, openings are formed on the parts of the passivation film 13 that overlap with the terminals 12.

The first insulation layer 30 and the second insulation layer 40 are laminated in the +Z side of the RFIC chip 10 and the mold resin 20. As a material for the first insulation layer 30 and the second insulation layer 40, a transparent resin (for example, polyimide or the like) is preferable. By having the first insulation layer 30 and the second insulation layer 40 be transparent, it is possible to make the inspection of whether or not the redistributors 50 and the solder bumps B overlap with the high frequency circuit block 11 easier.

As a material for the redistributor 50, it is possible to adopt copper. The redistributor 50 includes a terminal joining part 51, a penetration part 52, and a fan out part 53. The terminal joining part 51 is joined to the terminal 12. The penetration part 52 extends from the terminal joining part 51 to the +Z side, and penetrates the first insulation layer 30 in a thickness direction. The fan out part 53 extends in a direction orthogonal to the thickness direction, and in the planar view, is disposed to straddle the boundary of the RFIC chip 10 and the mold resin 20. In the example of FIG. 2, the solder bumps B are joined to the part of the fan out part 53 that overlaps with the mold resin 20 in the planar view. From this, it is possible to connect the solder bumps B (high frequency bumps Bs) that are disposed in a position that overlaps with the mold resin 20 with the terminals 12 (high frequency terminals 12s). However, it is possible to change the shape of the redistributor 50 accordingly. For example, the redistributor 50 connecting the first bump group G1 and the terminals 12 may not include a fan out part.

In the present embodiment, all of the high frequency terminals 12s that the RFIC chip 10 includes are each connected to the second bump group G2 by means of the redistributors 50. In other words, out of the plurality of solder bumps B that the semiconductor package 1 includes, all of the high frequency bumps Bs are included in the second bump group G2.

In the present embodiment, all of the digital signal terminals 12d that the RFIC chip 10 includes are each connected to the first bump group G1 by means of the redistributors 50. In other words, out of the plurality of solder bumps B that the semiconductor package 1 includes, all of the digital bumps Bd are included in the first bump group G1. Out of the plurality of solder bumps B that the semiconductor package 1 includes, the GND bumps Bg is included in both the first bump group G1 and the second bump group G2.

For example, the solder bumps B included in a region A1 shown in FIG. 1 are all GND bumps Bg. The region A1 is provided in two locations on the outermost circumferential part (in the vicinity of two sides parallel to the first centerline X) of the semiconductor package 1. According to this disposition, the GND bumps Bg included in the region A1 function as a shield, and it is possible to suppress interference of the high frequency signal between the semiconductor package 1 and the surroundings.

All of the solder bumps B included in a region A2 shown in FIG. 1 are digital bumps Bd. The region A2 is provided in the center part (in the vicinity of the second centerline Y) of the semiconductor package 1 in the X direction. Although a digital signal flows through the digital bumps Bd, the effect that the digital signal has on the high frequency circuit block 11 is small. For this reason, even if the digital bumps Bd are densely disposed in the vicinity of the high frequency circuit block 11, it is possible to maintain the high frequency characteristics of the semiconductor package 1. In the present embodiment, by densely disposing all of the digital bumps Bd so that the digital bumps Bd overlap with the RFIC chip 10 in a planar view, it is possible to minimize the size of the semiconductor package 1.

It is preferable that the high frequency bumps Bs are surrounded by a plurality of GND bumps Bg. For example, out of the six solder bumps B in a region A3 shown in FIG. 1, one is a high frequency bump Bs, and the remaining five are GND bumps Bg. The five GND bumps Bg are disposed so as to surround the high frequency bump Bs. When disposed in this manner, the GND bumps Bg act as a shield suppressing noise radiated from the high frequency bump Bs or a shield suppressing noise of the surrounding space from affecting the high frequency signal that flows through the high frequency bump Bs. Similarly, out of the three solder bumps B included in a region A4, one is a high frequency bump Bs and the remaining two are GND bumps Bg. The two GND bumps Bg are disposed so as to sandwich the high frequency bump Bs. Also when the high frequency bump Bs is disposed in such a way that the high frequency bump Bs is sandwiched by two or more GND bumps Bg, it is possible to obtain the noise suppression effect to some extent.

It is preferable to determine the disposition of the high frequency circuit block 11 in order to minimize the size of the RFIC chip 10 as much as possible. With respect to the overall cost of the semiconductor package 1, since the RFIC chip 10 occupies a large percentage of the cost, downsizing the RFIC chip 10 contributes to the cost suppression of the semiconductor package 1. In the present embodiment, in order to downsize the RFIC chip 10, the disposition of the high frequency circuit block 11 is determined on priority, and consequently the pitches of the solder bumps B become uneven.

The solder bumps B are disposed to be symmetrical with respect to both the first centerline X and the second centerline Y. According to the above disposition, when heating the solder bumps B to mount the semiconductor package 1 on the substrate 2, the temperature distribution that occurs in the semiconductor package 1 and the substrate 2 is approximately symmetric with respect to the first centerline X and the second centerline Y. From this, the occurrence of asymmetrical thermal stresses is suppressed, making it possible to increase the mounting reliability. Further, the term "symmetrical" includes a disposition that is deemed as symmetrical after manufacturing errors have been factored out.

As shown in FIG. 3, a plurality of via holes 2b are formed in the substrate 2. The via hole 2b may be a through hole via, or may be a blind via. The pads (high frequency pads 2s, GND pads 2g or the like) are formed on top of the via holes 2b. In other words, the configuration known as "pad on via construction" is adopted. The high frequency pads 2s are joined with the high frequency bumps Bs, and the GND pads 2g are joined with the GND bumps Bg.

The high frequency pads 2s are connected to an antenna 2c (for example, a patch antenna or the like) by means of the via holes 2b. It is possible to refer to the high frequency module 3 as the antenna module.

The GND pads 2g are connected to a GND layer 2d of the substrate 2 by means of the via holes 2b.

The minimum pitch in the second bump group G2 is larger than the minimum pitch in the first bump group G1. "Pitch" here refers to the distance between centers of the two solder bumps B that are side by side. The term "minimum pitch in the first bump group G1" is the minimum value of the pitch between the solder bumps B included in the first bump group G1. The term "minimum pitch in the second bump group G2" is the minimum value of the pitch between the solder bumps B included in the second bump group G2. As an example, the minimum pitch in the second bump group G2 is more than or equal to 0.5 mm, and the minimum pitch in the first bump group G1 is less than or equal to 0.4 mm. By making the minimum pitch of the first bump group G1 small, the size of the RFIC chip 10 becomes smaller, making cost reduction possible. The high frequency bumps Bs are included in the second bump group G2. The effect that the disposition of the high frequency pads 2s on the substrate 2 has on the high frequency characteristics of the high frequency module 3 is large. As such, there are many restrictions regarding the disposition of the high frequency pads 2s. Here, by making the minimum pitch of the second bump group G2 in which the high frequency bumps Bs joined to the high frequency pads 2s are included larger, the degree of freedom of dispositioning the high frequency circuit on the substrate 2 increases, making it easier to maintain the high frequency characteristics. Also, by making the minimum pitch of the second bump group G2 larger, routing of the high frequency circuit on the inside of the substrate 2 becomes easier, making it possible to downsize the substrate 2.

In the substrate 2, it is preferable that the parts joined to the second bump group G2 are made to be a pad on via construction as shown in FIG. 3. In adopting a construction as such, routing of the high frequency circuit on the inside of the substrate 2 becomes much easier, lowering the difficulty of substrate design and making cost reduction possible. Also, by making the transmission distance inside the substrate 2 smaller, it is possible to obtain the effect of making the high frequency signal losses smaller.

As explained above, the semiconductor package 1 of the present embodiment includes the RFIC chip 10 that includes the plurality of terminals 12, the mold resin 20 that surrounds the RFIC chip 10 in a planar view, the plurality of solder bumps B, the plurality of redistributors 50 that connect the plurality of terminals 12 to the plurality of solder bumps B. In the plurality of terminals 12, the GND terminals 12g and the high frequency terminals 12s are included, and in the plurality of solder bumps B, the first bump group G1 disposed in a position that overlaps the RFIC chip 10 in the planar view, and the second bump group G2 disposed in a position that overlaps the mold resin 20 in the planar view are included. In the second bump group G2, at least the high frequency bumps Bs connected to the high frequency terminals 12s, and the GND bumps Bg connected to the GND terminals 12g are included, and a minimum pitch in the second bump group G2 is larger than a minimum pitch in the first bump group G1. According to the above configuration, the degree of freedom of dispositioning the high frequency circuit on the substrate 2 increases, making it easier to maintain the high frequency characteristics. Further, according to the above configuration, routing of the high frequency circuit on the inside of the substrate 2 becomes easier, making it possible to downsize the substrate 2.

The plurality of redistributors 50 and the plurality of solder bumps B are disposed so as not to overlap in the planar view with respect to the high frequency circuit block 11 that the RFIC chip 10 includes. According to such a configuration, it is possible to suppress the effects that the metallic elements have on the high frequency characteristics of the semiconductor package 1 and that may be brought upon by disposing the metallic elements so as to overlap with respect to the high frequency circuit block 11.

In the planar view, the plurality of solder bumps B that the semiconductor package 1 includes are disposed symmetrically to both the first centerline X and the second centerline Y that are orthogonal to one another. According to such a configuration, the occurrence of asymmetrical thermal stresses when mounting the semiconductor package 1 on the substrate 2 is suppressed, making it possible to increase the mounting reliability.

All of the high frequency terminals 12s that the RFIC chip 10 includes are connected to the second bump group G2. According to such a configuration, the high frequency pads 2s of the substrate 2 are joined to the second bump group G2 having a large pitch, which increases the degree of freedom of dispositioning the high frequency circuit on the substrate 2. Also, according to such a configuration, routing of the high frequency circuit on the inside of the substrate 2 becomes much easier, making it possible to downsize the substrate 2 even more.

All of the digital signal terminals 12d that the RFIC chip 10 includes may be connected to the first bump group G1. With respect to the circuit that deals with the digital signal in the substrate 2, restrictions on disposition are few, and the effects that the circuit has on the high frequency characteristics are small. Therefore, by connecting the circuit that deals with the digital signal to the first bump group G1 having a small pitch, it is possible to contribute to the downsizing of the circuit while suppressing the effects that the circuit has on the high frequency characteristics.

The RFIC chip 10 at least includes two high frequency circuit blocks 11b, and in the planar view, at least a part of the first bump group G1 may be positioned between the two high frequency circuit blocks 11b. Since terminals other than the high frequency terminals 12s (digital signal terminal 12d, GND terminal 12g of the like) are connected to the first bump group G1, even if the first bump group G1 is placed in the vicinity of the high frequency circuit block 11b, the effect that the first bump group G1 has on the high frequency characteristics is small. Therefore, the first group bumps G1 are densely disposed in the small gaps between the high frequency circuit blocks 11b, and effective use of space is made, making the overall downsizing of the semiconductor package 1 possible.

The high frequency module 3 of the present embodiment includes the semiconductor package 1, and the substrate 2 on which the semiconductor package 1 is mounted. As shown in FIG. 3, the substrate 2 includes the high frequency pad 2s joined to the high frequency bump Bs, and the GND pad 2g joined to the GND bump Bg. The high frequency pad 2s and the GND pad 2g are each disposed on via holes 2b formed in the substrate 2. In this manner, by joining the high frequency bumps Bs and the GND bumps Bg each to the pad on via construction of the substrate 2, it is possible to stabilize the high frequency characteristics of the high frequency module 3. Specifically, when joining the high frequency bumps Bs that have the plurality of GND bumps Bg surround the high frequency bumps Bs and the GND bumps Bg to the pad on via construction of the substrate 2, it is possible to realize a pseudo coaxial geometry, making it possible to further stabilize the high frequency characteristics. Routing of the high frequency circuit on the inside of the substrate 2 becomes much easier, lowering the difficulty of substrate design and making cost reduction possible.

Also, the technical scope of the present invention is not limited to the above described embodiments. Various changes may be added without departing from the objective and scope of the present invention.

For example, in the explanation above of the embodiments, the solder bumps B are disposed so as to be symmetrical to both the first centerline X and the second centerline Y. However, the solder bumps B may be disposed so as to be symmetrical to either one of the first centerline X or the second centerline Y, or may be disposed so as to be symmetrical to neither the first centerline X nor the second centerline Y. In this case, by controlling the heat generated when the semiconductor package 1 is mounted on the substrate 2, it is possible to maintain mounting reliability. Also, as a shape of the semiconductor package 1, a shape in which the first centerline X or the second centerline Y cannot be defined may be adopted.

In addition, without departing from the objective of the present invention, it is possible to appropriately replace the constituent elements in the above-described embodiments with well-known constituent elements, and the above-described embodiments and modification examples may be appropriately combined.

### [Explanation of Reference Symbols]

1 Semiconductor Package
2 Substrate
2b Via Hole
2g GND Pad
2s High Frequency Pad
3 High Frequency Module
10 RFIC Chip
11 High Frequency Circuit Block
12 Terminal
12d Digital Signal Terminal
12g GND Terminal
12s High Frequency Terminal
20 Mold Resin
50 Redistributor
B Bump
Bg GND Bump
Bs High Frequency Bump
G1 First Bump Group
G2 Second Bump Group
X First Centerline
Y Second Centerline

## Claims

1. A semiconductor package comprising:
an RFIC chip;
a mold resin that surrounds the RFIC chip in a planar view;
a plurality of solder bumps; and
a plurality of redistributors that connect the RFIC chip to the plurality of solder bumps; wherein,
a first bump group disposed in a position that overlaps with the RFIC chip in the planar view, and a second bump group disposed in a position that overlaps with the mold resin in the planar view are included in the plurality of solder bumps,
in the second bump group, at least a high frequency bump connected to a high frequency terminal of the RFIC chip, and a GND bump connected to a GND terminal of the RFIC chip are included, and
a minimum pitch in the second bump group is larger than a minimum pitch in the first bump group.

2. The semiconductor package according to claim 1, wherein
all the high frequency terminals that the RFIC chip includes are connected to the second bump group.

3. The semiconductor package according to claims 1 and 2, wherein
all digital signal terminals that the RFIC chip includes are connected to the first bump group.

4. The semiconductor package according to any one of claims 1 to 3, wherein
the plurality of redistributors and the plurality of solder bumps are disposed so as not to overlap in the planar view with respect to a high frequency circuit block that the RFIC chip includes.

5. The semiconductor package according to any one of claims 1 to 4, wherein
the RFIC chip at least includes two high frequency circuit blocks, and
in the planar view, at least a part of the first bump group is positioned between the two high frequency circuit blocks.

6. The semiconductor package according to any one of claims 1 to 5, wherein
in the planar view, the plurality of solder bumps are disposed symmetrically to both a first centerline and a second centerline that are orthogonal to one another.

7. A high frequency module comprising:
the semiconductor package according to any one of claims 1 to 6; and
a substrate on which the semiconductor package is mounted; wherein
the substrate includes a high frequency pad joined to the high frequency bump and a GND pad joined to the GND bump, and
the high frequency pad and the GND pad are each disposed on via holes formed in the substrate.

## Amended claims

### Amended claims under Art. 19.1 PCT

**1.** Original) A semiconductor package comprising:
an RFIC chip;
a mold resin that surrounds the RFIC chip in a planar view;
a plurality of solder bumps; and
a plurality of redistributors that connect the RFIC chip to the plurality of solder bumps; wherein,
a first bump group disposed in a position that overlaps with the RFIC chip in the planar view, and a second bump group disposed in a position that overlaps with the mold resin in the planar view are included in the plurality of solder bumps,
in the second bump group, at least a high frequency bump connected to a high frequency terminal of the RFIC chip, and a GND bump connected to a GND terminal of the RFIC chip are included, and
a minimum pitch in the second bump group is larger than a minimum pitch in the first bump group.

**2.** to 7. (Canceled)

**8.** Added) A semiconductor package comprising:
an RFIC chip;
a mold resin that surrounds the RFIC chip in a planar view;
a plurality of solder bumps; and
a plurality of redistributors that connect the RFIC chip to the plurality of solder bumps; wherein,
a first bump group disposed in a position that overlaps with the RFIC chip in the planar view, and a second bump group disposed in a position that overlaps with the mold resin in the planar view are included in the plurality of solder bumps,
in the second bump group, at least a high frequency bump connected to a high frequency terminal of the RFIC chip, and a GND bump connected to a GND terminal of the RFIC chip are included, and
a minimum pitch, which is a minimum value of a pitch between the high frequency bumps and the GND bumps included in the second bump group is larger than a minimum pitch in the first bump group which is a minimum value of a pitch between the solder bumps included in the first bump group.

**9.** Added) The semiconductor package according to claim 1 or 8, wherein
all the high frequency terminals that the RFIC chip includes are connected to the second bump group.

**10.** Added). The semiconductor package according to any one of claims 1, 8 and 9, wherein
all digital signal terminals that the RFIC chip includes are connected to the first bump group.

**11.** Added) The semiconductor package according to any one of claims 1 and 8 to 10, wherein
the plurality of redistributors and the plurality of solder bumps are disposed so as not to overlap in the planar view with respect to a high frequency circuit block that the RFIC chip includes.

**12.** Added) The semiconductor package according to any one of claims 1 and 8 to 11, wherein
the RFIC chip at least includes two high frequency circuit blocks, and
in the planar view, at least a part of the first bump group is positioned between the two high frequency circuit blocks.

**13.** Added) The semiconductor package according to any one of claims 1, and 8 to 12, wherein
in the planar view, the plurality of solder bumps are disposed symmetrically to both a first centerline and a second centerline that are orthogonal to one another.

**14.** Added) A high frequency module comprising:
the semiconductor package according to any one of claims 1 and 8 to 13; and
a substrate on which the semiconductor package is mounted; wherein
the substrate includes a high frequency pad joined to the high frequency bump and a GND pad joined to the GND bump, and
the high frequency pad and the GND pad are each disposed on via holes formed in the substrate.

Statement under Art. 19.1 PCT
Claim 8 is based on the contents of paragraphs [0015], [0019], [0026], [0032], [0035] and [0039] and FIG. 1 of the original description at the time of filing. Paragraph [0039] of the original description states that *"Also, by making the minimum pitch of the second bump group G2 larger, routing of the high frequency circuit on the inside of the substrate 2 becomes easier, making it possible to downsize the substrate 2. "* It is evident that in the present application, by making a minimum pitch in the second bump group G2 larger than a minimum pitch in the first bump group G1, the effect of increasing the degree of freedom of routing and of dispositioning the redistributors 50 connected to the high frequency bumps Bs in the second bump group G2 is achieved. From the contents of paragraph [0035] of the present application, because the high frequency bumps Bs included in the second bump group G2 are configured such that they are either surrounded by, or sandwiched by a plurality of the GND bumps Bg, the bumps dispositioned closest to the high frequency bumps Bs are the GND bumps Bg.

From the above configuration explained in paragraph [0035], in order to achieve the aforementioned effect, it is critical that the pitches between the high frequency bumps Bs, and the GND bumps Bg that are dispositioned closest to the high frequency bumps Bs be large. In this case, it is obvious that the technical feature of *"The minimum pitch in the second bump group G2 is larger than the minimum pitch in the first bump group G1."* disclosed in paragraph [0039] of the present application expresses the technical feature of *"The minimum pitch, which is the minimum value of the pitch between the high frequency bumps Bs and the GND bumps Bg included in the second bump group G2 is larger than the minimum pitch in the first bump group which is the minimum value of the pitch between the solder bumps included in the first bump group G1."* Therefore, the technical feature disclosed in claim 8 is within the scope of the original description of the present application.

As for claims 9 to 14, the contents are based off of the original claims 2 to 7, and are also included in the scope of the original description of the present application.
